# EUROPÄISCHE PATENTSCHRIFT

(11) **EP 0 645 827 B1**
(45) Veröffentlichungstag und Bekanntmachung des Hinweises auf die Patenterteilung: **11.02.1998**
(21) Anmeldenummer: 94114869.4
(22) Anmeldetag: 21.09.1994
(51) Int. Cl.: H01L 31/173, H01L 31/167

(54) **Optokoppler und Verfahren zu dessen Herstellung**
Optocoupler and process of manufacturing the same
Photocoupleur et procédé de fabrication

(30) Priorität: 23.09.1993 DE 4332449
(43) Veröffentlichungstag der Anmeldung: 29.03.1995
(73) Patentinhaber: SIEMENS AKTIENGESELLSCHAFT, 80333 München (DE)
(72) Erfinder: Späth, Werner, Dipl.-Phys., D-83607 Holzkirchen (DE); Stath, Norbert, Dr., Dipl.-Phys., D-93049 Regensburg (DE); Nirschl, Ernst, Dr., Dipl.-Phys., D-93173 Wenzenbach (DE); Wegleiter, Walter, Dipl.-Ing. (FH), D-93152 Nittendorf (DE); Kuhlmann, Werner, Dr.rer.nat., D-81541 München (DE); Buchberger, Rudolf, Dipl.-Ing., D-80469 München (DE)

(56) Entgegenhaltungen:
- DE-A- 1 639 414
- DE-A- 3 633 181
- DE-A- 3 633 251
- DE-A- 3 735 489
- US-A- 4 588 261

## Beschreibung

Die Erfindung bezieht sich auf einen Optokoppler nach dem Oberbegriff des Anspruches 1.

Optokoppler sind bekanntlich optoelektronische Halbleiterbauelemente, die für eine rückwirkungs- und potentialfreie Signalübertragung zwischen zwei galvanisch getrennten Schaltkreisen verwendet werden. Optokoppler bestehen aus einem lichtemittierenden Halbleiterbauelement als optischen Sender und einem lichtdetektierenden Halbleiterbauelement als optischen Empfänger, die in einem Gehäuse integriert optisch miteinander gekoppelt, elektrisch aber gegeneinander isoliert sind. Als optischer Sender wird beispielsweise eine im sichtbaren oder infrarotem Wellenlängenbereich lichtemittierende Diode (LED oder IRED) und als optischer Empfänger eine Fotodiode oder ein Fototransistor verwendet. Gebräuchlich ist z.B. die Verbindung einer GaAs-IRED mit einem Si-Fototransistor, da sich beide Komponenten gut aufeinander abstimmen lassen. Das Emissionsmaximum der Galliumarseniddiode stimmt dabei mit der höchsten spektralen Empfindlichkeit des Siliziumtransistors nahezu überein.

Beispielsweise sind die Vorteile von Optokopplern gegenüber mechanischen Relais das Fehlen jeglicher bewegter Teile, die lange Lebensdauer, ihre Kleinheit, ihre Kompatibilität mit Halbleiterschaltungen und vor allem ihre hohe Schaltfrequenz.

Aus der DE-OS 37 13 067 ist ein Optokoppler bekannt, bei dem ein Senderchip und ein Empfängerchip über ein optisches Koppelmedium fest miteinander verbunden sind. Das Koppelmedium ist eine isolierende, transparente Zwischenschicht. Der Senderchip, das Koppelmedium und der Empfängerchip sind übereinandergeschichtet direkt miteinandedr verbunden.

Aus der DE-OS 36 33 251 ist außerdem ein Optokoppler bekannt, bei dem ein optischer Senderchip und ein optischer Empfängerchip direkt über ein Koppelmedium miteinander verbunden sind, das aus einem transparenten Kleber oder einem Glaslot besteht. Diesem Koppelmedium können als transparente Abstandspartikel Glasfaserabschnitte oder Glaskugeln hinzugefügt sein.

Der Erfindung liegt die Aufgabe zugrunde, einen kostengünstigen Optokoppler mit hohem Koppelfaktor und hoher Reproduzierbarkeit zu schaffen, der sich durch geringen Raumbedarf auszeichnet, die Realisierung von Mehrfachkopplern auf engstem Raum ermöglicht und für den Einsatz in SMT-fähigen Gehäusebauformen geeignet ist.

Diese Aufgabe wird bei einem Optokoppler der eingangs genannten Art erfindungsgemäß durch die Merkmale des Anspruches 1 gelöst.

Vorteilhafte Ausgestaltungen bzw. Weiterbildungen der Erfindung sind Gegenstand zusätzlicher Ansprüche.

Die mit der Erfindung erzielten Vorteile bestehen insbesondere darin, daß sich der Optokoppler durch geringen Raumbedarf auszeichnet, so daß dieser Optokoppler zum Einsatz in kleinen Gehäusebauformen geeignet ist, die zudem SMT (Surface Mount Technology)-fähig ausgebildet sein können. Außerdem lassen sich mit diesem Koppler in einem gemeinsamen Gehäuse auf engstem Raum auch Mehrfachkoppler realisieren. Darüber hinaus besitzt der vorgeschlagene Optokoppler einen hohen Koppelfaktor und ist aufgrund seiner einfachen Bau- und Herstellweise auch besonders kostengünstig.

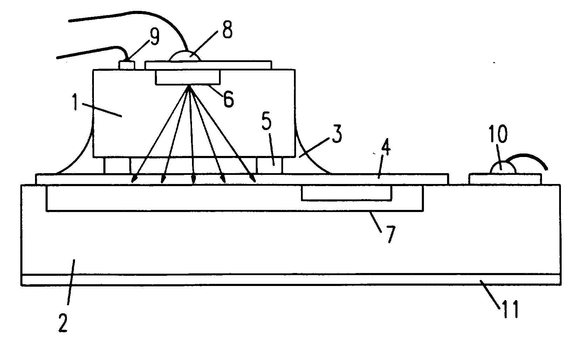

Anhand eines in der Figur der Zeichnung dargestellten Ausführungsbeispiels wird die Erfindung im folgenden näher erläutert.

Der in der Figur schematisch im Schnitt dargestellte Optokoppler besteht im wesentlichen aus einem lichtemittierenden Halbleiterbauelement als Senderchip 1 und einem lichtdetektierenden Halbleiterbauelement als Empfängerchip 2, die über ein optisches Koppelmedium elektrisch gegeneinander isoliert, mechanisch fest miteinander verbunden sind. Das optische Koppelmedium ist aus einer auf den Empfängerchip 2 aufgebrachten, transparenten Isolierschicht 4, einer auf der Isolierschicht 4 aufgebrachten, transparenten, strukturierten Abstandsschicht 5 aus elektrisch isolierendem Material und aus einer transparenten bzw. lichtdurchlässigen Verbindungsschicht 3 gebildet, welche die Zwischenräume der strukturierten Abstandsschicht 5 ausfüllt und den Senderchip 1 mit dem Empfängerchip 2 fest verbindet. Der Senderchip 1 ist beispielsweise eine GaAs-IRED und der Empfängerchip ein Si-Fototransistor. Die Verbindungsschicht 3 besteht vorzugsweise aus einem transparenten Kleber. Als Verbindungsmedium kann aber beispielsweise auch ein Glaslot verwendet werden. Die transparente Isolierschicht 4, die auf den Empfängerchip 2 aufgebracht wird, ist vorzugsweise eine SiO₂-Schicht, eine Al₂O₃-Schicht oder eine Si₃N₄-Schicht. Die strukturierte Abstandsschicht 5 besteht zweckmäßig aus einem lichtdurchlässigen Polyimid.

Gemäß der Erfindung weist die Abstandsschicht 5 eine Stegstruktur auf. Es sind mehrere Stege vorgesehen, die von einem stegfreien Innen- bzw. Zentralbereich auf der Oberfläche der Isolierschicht 4 im Bereich der lichtempfindlichen Fläche des Empfängerchips 2 radial nach außen verlaufen. In einer vorteilhaften Ausführung sind die Stege von einem Randsteg 5 umschlossen.

Die einzelnen bzw. aus einem Wafer vereinzelten Senderchips 1 werden vorzugsweise auf den die Empfängerchips 2 im Verband enthaltenden Wafer aufgeklebt (Chip on Chip). Der jeweilige Senderchip 1 wird dabei "upside up" aufgeklebt. Das bedeutet, daß der Senderchip 1 mit seiner, der mit den Kontakten 8, 9 versehenen Chipkontaktseite gegenüberliegenden Lichtaustrittfläche über das optische Koppelmedium 3, 4, 5 mit der fotoempfindlichen Fläche des Empfängerchips 2 verbunden ist. Der Abstand zwischen Senderchip 1 und Empfängerchip 2 ist dabei zweckmäßig kleiner als 100 µm und wird mit besonderem Vorteil durch die Abstandsschicht 5 in sehr engen Toleranzen gehalten. Von weiterem Vorteil ist, daß durch den geringen Abstand der beiden Chips 1, 2 hohe Koppelfaktoren erzielt werden können, ohne daß dabei eine geforderte Hochspannungsfestigkeit von ca. 2,5 kV beeinträchtigt wird.

Die Baugröße des Optokopplers wird durch das bevorzugt angewendete Verkleben der Chips (Chip/Chip-Verklebung) klein.

Außerdem wird durch diesen Aufbau erreicht, daß bei einer Realisierung von Mehrfachkopplern kein optisches Übersprechen auftritt. Darüber hinaus können die Koppelelemente eng gepakt in ein Gehäuse eingebaut werden, das mit besonderem Vorteil SMT-fähig gestaltbar ist. Vor allem durch die Realisierung der Kopplerfunktion im Waferverband wird es möglich, kostengünstige Optokoppler herzustellen.

Als Senderchip 1 wird beispielsweise eine IR-Sendediode verwendet, deren am pn-Übergang 6 erzeugte optische Strahlung über die Chiprückseite ausgekoppelt wird. Beide Kontakte, der p-Kontakt 8 und der n-Kontakt 9, sind auf der Vorderseite des Senderchips 1 angebracht, der z.B. in Planartechnik hergestellt ist. Die Chipdicke des Senderchips 1 ist zweckmäßig kleiner als 120 µm. Der Senderchip 1 ist im Übergangsbereich zum Koppelmedium 3, 4, 5 kleinflächiger ausgebildet, und zwar derart, daß die fotoempfindliche Fläche des Emfängerchips 2 an die Abstrahlcharakteristik des Senderchips 1 angepaßt ist.

Als Empfängerchip 2 wird beispielsweise ein Si-Fototransistor verwendet. Zur Erhöhung der Isolationsfestigkeit, ist der Empfängerchip 2 mit einer Al₂O₃-Schicht, einer Si₃N₄-Schicht oder einer SiO₂-Schicht als Isolierschicht 4 bedeckt. Diese Isolierschicht 4 ist als Teil des Koppelmediums für die vom Senderchip 1 emittierte Strahlung transparent. Der definierte Abstand zwischen Senderchip 1 und Empfängerchip 2 ist durch die Abstandsschicht 5 gewährleistet, die als strukturierte Isolierschicht, vorzugsweise Polyimidschicht, auf die Isolierschicht 4 aufgebracht ist. Die Größe der fotoempfindlichen Fläche des Empfängerchips 2 bzw. dessen pn-Übergangs 7, der diese Fläche bestimmt, ist an die Abstrahlcharakteristik der am pn-Übergang 6 des Senderchips 1 erzeugten optischen Strahlung angepaßt. Der Kollektorkontakt 11 des Empfängerchips 2 ist auf dessen der fotoempfindlichen Fläche abgewandten Chiprückseite ganzflächig ausgebildet. Der Basiskontakt 10 und ein nicht dargestellter, weil zum Basiskontakt 10 versetzt angeordneter Emitterkontakt befinden sich auf der Chipvorderseite des Empfängerchips 2. Das Pad-Design ist so realisiert, daß die Kontaktverbindungen bzw. Bonddrähte von den Kontakten 8, 9, 10 seitlich nach außen verlaufen, um eine möglichst hohe Isolationsfestigkeit des Optokopplers zu erreichen.

## Patentansprüche

1. Optokoppler, bei dem ein lichtemittierendes Halbleiterbauelement als Senderchip (1) und ein lichtdetektierendes Halbleiterbauelement als Empfängerchip (2) über ein optisches Koppelmedium elektrisch gegeneinander isoliert, mechanisch fest miteinander verbunden sind und bei dem das Koppelmedium eine transparente Abstandsschicht (5) mit einem oder mehreren Zwischenräumen und eine transparente Verbindungsschicht (3) aufweist, die die Zwischenräume ausfüllt und den Senderchip (1) mit dem Empfängerchip (2) fest verbindet, **dadurch gekennzeichnet**, dass auf dem Empfängerchip (2) eine transparente Isolierschicht (4) aufgebracht ist und dass die Abstandsschicht (5) strukturiert auf der Isolierschicht (4) aufgebracht ist und mehrere Stege aufweist, die von einem Stegfreien Zentralbereich radial nach außen verlaufen.

2. Optokoppler nach Anspruch 1, **dadurch gekennzeichnet,** daß die Verbindungsschicht (3) aus einem transparenten Kleber besteht.

3. Optokoppler nach Anspruch 1 oder 2, **dadurch gekennzeichnet**, daß die transparente Isolierschicht (4) eine Siliziumoxidschicht, eine Aluminiumoxidschicht oder eine Siliziumnitridschicht ist.

4. Optokoppler nach einem der Ansprüche 1 bis 3, **dadurch gekennzeichnet,** daß die strukturierte Abstandsschicht (5) ein Polyimidschicht ist.

5. Optokoppler nach einem der Ansprüche 1 bis 4, **dadurch gekennzeichnet**,
dass die Stege an ihren Außenenden von einem Randsteg umschlossen sind.

6. Optokoppler nach einem der Ansprüche 1 bis 5, **dadurch gekennzeichnet,** daß der Senderchip (1) im Übergangsbereich zum Koppelmedium (3, 4, 5) kleinflächiger ist als der Empfängerchip (2), wobei die fotoempfindliche Fläche des Empfängerchips (2) an die Abstrahlungscharakteristik des Senderchips (1) angepaßt ist.

7. Optokoppler nach einem der Ansprüche 1 bis 6, **dadurch gekennzeichnet**, daß der Abstand zwischen dem lichtemittierenden Halbleiterbauelement und dem lichdetektierenden Halbleiterbauelement kleiner als 100 µm ist.

8. Optokoppler nach einem der Ansprüche 1 bis 7, **dadurch gekennzeichnet**, daß das lichtemittierende Halbleiterbauelement zusammen mit dem lichtdetektierenden Halbleiterbauelement in ein SMT-fähiges Gehäuse eingebaut ist.

9. Optokoppler nach einem der Ansprüche 1 bis 8, **dadurch gekennzeichnet**, daß mehrere lichtemittierende Halbleiterbauelemente zusammen mit dem jeweils zugehörigen lichtdetektierenden Halbleiterbauelement in ein gemeinsames SMT-Ghäuse eingebaut sind.

10. Verfahren zum Herstellen eines Optokopplers nach einem der Ansprüche 1 bis 9, **dadurch gekennzeichnet,** daß eine Vielzahl von Empfängerchips (2) im Scheibenverband mit einer transparenten Isolierschicht (4) und einer transparenten, strukturierten Abstandsschicht (5) aus elektrisch isolierenden Material versehen werden, daß auf diese Schichten eine transparente Verbindungsschicht (3) aufgebraucht wird, daß jeweils ein Senderchip (1) mit seiner Lichtaustrittseite auf die Lichtempfangsseite eines kontaktierten Empfängerchips (2) aufgebracht wird, daß die Empfängerchips (2) mit ihren zugeordneten Senderchips (1) aus dem Scheibenverband vereinzelt werden, und daß ein oder mehrere vereinzelte Empfängerchips (2) mit ihren Senderchips (1) von einem Kunststoffgehäuse umhüllt werden.

## Claims

1. Optocoupler, in which a light-emitting semiconductor component as transmitter chip (1) and a light-detecting semiconductor component as receiver chip (2) are mechanically permanently connected to each other and electrically insulated from each other via an optical coupling medium, and in which the coupling medium has a transparent spacing layer (5) with one or more interspaces and a transparent connecting layer (3), which fills up the interspaces and permanently connects the transmitter chip (1) to the receiver chip (2), characterized in that a transparent insulating layer (4) is applied on the receiver chip (2), and in that the spacing layer (5) is applied in a structured manner on the insulating layer (4) and has a plurality of webs which extend radially outwards from a web-free central region.

2. Optocoupler according to Claim 1, characterized in that the connecting layer (3) consists of a transparent adhesive.

3. Optocoupler according to Claim 1 or 2, characterized in that the transparent insulating layer (4) is a silicon oxide layer, an aluminium oxide layer or a silicon nitride layer.

4. Optocoupler according to one of Claims 1 to 3, characterized in that the structured spacing layer (5) is a polyimide layer.

5. Optocoupler according to one of Claims 1 to 4, characterized in that the webs are enclosed at their outer ends by a marginal web.

6. Optocoupler according to one of Claims 1 to 5, characterized in that the transmitter chip (1) has a smaller area in the transition region to the coupling medium (3, 4, 5) than the receiver chip (2), the photosensitive area of the receiver chip (2) being matched to the radiation characteristics of the transmitter chip (1).

7. Optocoupler according to one of Claims 1 to 6, characterized in that the distance between the light-emitting semiconductor component and the light-detecting semiconductor component is less than 100 µm.

8. Optocoupler according to one of Claims 1 to 7, characterized in that the light-emitting semiconductor component, together with the light-detecting semiconductor component, is built into a housing suitable for surface mount technology (SMT).

9. Optocoupler according to one of Claims 1 to 8, characterized in that a plurality of light-emitting semiconductor components, together with the respectively associated light-detecting semiconductor component, are built into a common SMT housing.

10. Method of producing an optocoupler according to one of Claims 1 to 9, characterized in that a multiplicity of receiver chips (2) are provided in the wafer assembly with a transparent insulating layer (4) and a transparent structured spacing layer (5) made of electrically insulating material, in that a transparent connecting layer (3) is applied to these layers, in that in each case a transmitter chip (1) is applied with its light exit side onto the light-receiving side of a receiver chip (2) with which it is in contact, in that the receiver chips (2) with their associated transmitter chips (1) are separated from the wafer assembly, and in that one or more separated receiver chips (2) with their transmitter chips (1) are covered by a plastic housing.

## Revendications

1. Coupleur optique, dans lequel un composant photoémetteur à semi-conducteurs faisant office de puce émettrice (1) et un composant photodétecteur à semi-conducteurs faisant office de puce réceptrice (2) sont isolés électriquement l'un par rapport à l'autre par l'intermédiaire d'un milieu de couplage optique, reliés solidairement entre eux du point de vue mécanique, et dans lequel le milieu de couplage comporte une couche d'écartement (5) transparente ayant un ou plusieurs interstices et une couche de liaison (3) transparente, qui comble les interstices et relie solidairement la puce émettrice (1) à la puce réceptrice (2), caractérisé par le fait qu'une couche isolante (4) transparente est appliquée sur la puce réceptrice (2), et que la couche d'écartement (5) est appliquée sur la couche isolante (4) en étant structurée, et qu'elle comporte plusieurs nervures qui s'étendent radialement vers l'extérieur à partir d'une zone centrale non nervurée.

2. Coupleur optique selon la revendication 1, caractérisé par le fait que la couche de liaison (3) est constituée d'une colle transparente.

3. Coupleur optique selon la revendication 1 ou 2, caractérisé par le fait que la couche isolante (4) transparente est une couche d'oxyde de silicium, une couche d'oxyde d'aluminium ou une couche de nitrure de silicium.

4. Coupleur optique selon l'une des revendications 1 à 3, caractérisé par le fait que la couche d'écartement (5) structurée est une couche en polyimide.

5. Coupleur optique selon l'une des revendications 1 à 4, caractérisé par le fait que les extrémités extérieures des nervures sont entourées par une nervure de bord.

6. Coupleur optique selon l'une des revendications 1 à 5, caractérisé par le fait que la puce émettrice (1) est de plus petite surface que la puce réceptrice (2) dans la zone de transition vers le milieu de couplage (3, 4, 5), la surface photosensible de la puce réceptrice (2) étant adaptée à la caractéristique d'émission de la puce émettrice (1).

7. Coupleur optique selon l'une des revendications 1 à 6, caractérisé par le fait que la distance entre le composant photoémetteur à semi-conducteurs et le composant photodétecteur à semi-conducteurs est inférieure à 100 µm.

8. Coupleur optique selon l'une des revendications 1 à 7, caractérisé par le fait que le composant photoémetteur à semi-conducteurs est inséré avec le composant photodétecteur à semi-conducteurs dans un boîtier compatible avec la SMT.

9. Coupleur optique selon l'une des revendications 1 à 8, caractérisé par le fait que plusieurs composants photoémetteurs à semi-conducteurs sont insérés avec les composants photodétecteurs à semi-conducteurs associés dans un boîtier SMT commun.

10. Procédé destiné à la fabrication d'un coupleur optique selon l'une quelconque des revendications 1 à 9, caractérisé par le fait qu'une pluralité de puces réceptrices (2) sont revêtues dans la tranche semiconductrice d'une couche isolante (4) transparente et d'une couche d'écartement (5) structurée et transparente en matériau électriquement isolant, qu'une couche de liaison (3) transparente est appliquée sur ces couches, qu'une puce émettrice (1) est à chaque fois fixée par sa face de sortie de lumière sur la face photoréceptrice d'une puce réceptrice (2) contactée, que les puces réceptrices (2) avec leurs puces émettrices (1) associées sont individualisées à partir de la tranche semiconductrice, et que une ou plusieurs puces réceptrices (2) individualisées avec leurs puces émettrices (1) sont entourées d'un boîtier en matière plastique.
